# FASCICULE DE BREVET EUROPEEN

(11) **EP 2 417 646 B1**
(45) Date de publication et mention de la délivrance du brevet: **07.11.2012**
(21) Numéro de dépôt: 10723235.7
(22) Date de dépôt: 09.04.2010
(51) Int. Cl.: H01L 43/08, H03B 15/00

(54) **OSCILLATEUR RADIOFRÉQUENCE À VANNE DE SPIN OU À JONCTION TUNNEL, PROCÉDÉ D'AJUSTEMENT DE LA FRÉQUENCE D'UN TEL OSCILLATEUR ET RÉSEAU CONSTITUÉ D'UNE PLURALITÉ DE TELS OSCILLATEURS**
SPIN-VALVE- ODER TUNNEL-JUNCTION-HOCHFREQUENZOSZILLATOR, PROZESS ZUM EINSTELLEN DER FREQUENZ EINES SOLCHEN OSZILLATORS UND AUS MEHREREN SOLCHEN OSZILLATOREN BESTEHENDES NETZWERK
SPIN-VALVE OR TUNNEL-JUNCTION RADIO-FREQUENCY OSCILLATOR, PROCESS FOR ADJUSTING THE FREQUENCY OF SUCH AN OSCILLATOR AND NETWORK CONSISTING OF A PLURALITY OF SUCH OSCILLATORS

(30) Priorité: 09.04.2009 FR 0952319
(43) Date de publication de la demande: 15.02.2012
(73) Titulaire: Commissariat à l'Énergie Atomique et aux Énergies Alternatives, 75015 Paris (FR); Institut Polytechnique de Grenoble, 38000 Grenoble (FR)
(72) Inventeur: DIENY, Bernard, F-38250 Lans En Vercors (FR); CYRILLE, Marie-Claire, F-38650 Sinard (FR); EBELS, Ursula, F-38100 Grenoble (FR); PREJBEANU, Liliana, F-38360 Sassenage (FR)
(74) Mandataire: Vuillermoz, Bruno
(86) Numéro de dépôt international: PCT/FR2010/050685
(87) Numéro de publication internationale: WO 2010/116102

(56) Documents cités:
- FR-A- 2 892 871
- US-A1- 2008 112 094
- VUKADINOVIC ET AL: "High-frequency response of nanostructured magnetic materials" JOURNAL OF MAGNETISM AND MAGNETIC MATERIALS, ELSEVIER SCIENCE PUBLISHERS, AMSTERDAM, NL LNKD- DOI:10.1016/J.JMMM.2009.01.049, vol. 321, no. 14, 14 mars 2009 (2009-03-14), pages 2074-2081, XP026087238 ISSN: 0304-8853 [extrait le 2009-03-14]
- FINOCCHIO G ET AL: "Spin-torque-induced rotational dynamics of a magnetic vortex dipole" PHYSICAL REVIEW B (CONDENSED MATTER AND MATERIALS PHYSICS) AMERICAN PHYSICAL SOCIETY BY AIP USA, vol. 78, no. 17, 1 novembre 2008 (2008-11-01), XP002594640 ISSN: 1098-0121
- FINOCCHIO G ET AL: "Magnetic vortex driven by non-uniform injection of spin-polarized current in nano-scale spin valves" JOURNAL OF MAGNETISM AND MAGNETIC MATERIALS, ELSEVIER SCIENCE PUBLISHERS, AMSTERDAM, NL LNKD- DOI:10.1016/J.JMMM.2008.10.017, vol. 321, no. 6, 1 mars 2009 (2009-03-01), pages 602-606, XP025995364 ISSN: 0304-8853 [extrait le 2008-10-29]
- KLAUI M ET AL: "Spin switching phase diagram of mesoscopic ring magnets" JOURNAL OF MAGNETISM AND MAGNETIC MATERIALS, ELSEVIER SCIENCE PUBLISHERS, AMSTERDAM, NL LNKD- DOI:10.1016/J.JMMM.2004.11.226, vol. 290-291, 1 avril 2005 (2005-04-01), pages 61-67, XP004800031 ISSN: 0304-8853
- CASTANO F J ET AL: "Magnetic configurations in 160-520-nm-diameter ferromagnetic rings" PHYSICAL REVIEW B (CONDENSED MATTER AND MATERIALS PHYSICS) APS THROUGH AIP USA, vol. 69, no. 14, 1 avril 2004 (2004-04-01) , pages 144421-1, XP002594641 ISSN: 0163-1829
- NAKATANI R ET AL: "Magnetization reversal with in-plane magnetic field in asymmetric ring dots" JAPANESE JOURNAL OF APPLIED PHYSICS, PART 1 (REGULAR PAPERS, SHORT NOTES & REVIEW PAPERS) JAPAN SOC. APPL. PHYS JAPAN, vol. 42, no. 1, janvier 2003 (2003-01), pages 100-101, XP002594642 ISSN: 0021-4922
- BEDAU D ET AL: "Detection of current-induced resonance of geometrically confined domain walls" PHYSICAL REVIEW LETTERS PUBLISHED FOR THE AMERICAN PHYSICAL SOCIETY BY THE AMERICAN INSTITUTE OF PHYSICS USA, vol. 99, no. 14, 5 octobre 2007 (2007-10-05), pages 1-4, XP002594643 ISSN: 0556-2813

## Description

### DOMAINE DE L'INVENTION

La présente invention se place dans le domaine des oscillateurs radiofréquence mettant en oeuvre la technologie des systèmes magnétiques en couches minces.

Elle vise plus particulièrement de tels oscillateurs radiofréquences mettant en oeuvre des vannes de spin ou des jonctions tunnel magnétiques comportant un empilement magnétique d'au moins une couche magnétique libre, une couche magnétique piégée, lesdites couches étant interfacées par une couche intermédiaire amagnétique.

### ETAT ANTERIEUR DE LA TECHNIQUE

Les oscillateurs radiofréquences sont destinés à fonctionner dans des gammes de fréquences élevées, typiquement comprises entre quelques dizaines de mégahertz et quelques dizaines de gigahertz.

Afin de satisfaire les exigences nées du développement des applications nomades, notamment de la téléphonie mobile (cellulaires, portables), en raison de la saturation des bandes de fréquences attribuées aux télécommunications, il a été proposé de remplacer l'allocation statique desdites bandes de fréquence par une allocation dynamique. Ce principe repose sur la capacité d'analyser le spectre de fréquences, et d'identifier les bandes de fréquence libres afin de pouvoir les utiliser. On parle alors de « radio opportuniste ».

Cependant, afin de mettre en oeuvre ce principe d'allocation dynamique de fréquences, les dispositifs le mettant en oeuvre doivent disposer d'oscillateurs à très larges bandes, et par ailleurs être très performants en termes de bruit de phase, et donc à fort coefficient de qualité Q = f/Δf.

Une solution technique propre à satisfaire ces exigences consiste en la mise en oeuvre d'oscillateurs radiofréquences basés sur l'électronique de spin utilisant le phénomène de transfert de spin. Avec de tels oscillateurs, on dispose d'une large accordabilité en fréquence dans une gamme de fréquences allant de quelques centaines de MHz à quelques dizaines de GHz tout en ayant un facteur de qualité Q élevé, et en mettant en oeuvre une architecture relativement simple.

L'électronique de spin utilise le spin des électrons comme degré de liberté supplémentaire par rapport à l'électronique conventionnelle qui n'utilise que la charge des électrons, afin de générer des effets nouveaux.

On a ainsi montré qu'en faisant passer un courant polarisé en spin à travers une couche mince magnétique, on peut produire un renversement de son aimantation en l'absence de tout champ magnétique extérieur. Ce phénomène est connu sous le nom de transfert de spin. Dans certaines géométries, le courant polarisé en spin peut également générer des excitations magnétiques entretenues, également dénommées oscillations. L'utilisation de l'effet de génération d'excitations magnétiques entretenues dans un dispositif magnétorésistif permet de convertir cet effet en une modulation de résistance électrique, directement utilisable dans les circuits électroniques, et donc corolairement, susceptible d'intervenir directement au niveau de la fréquence.

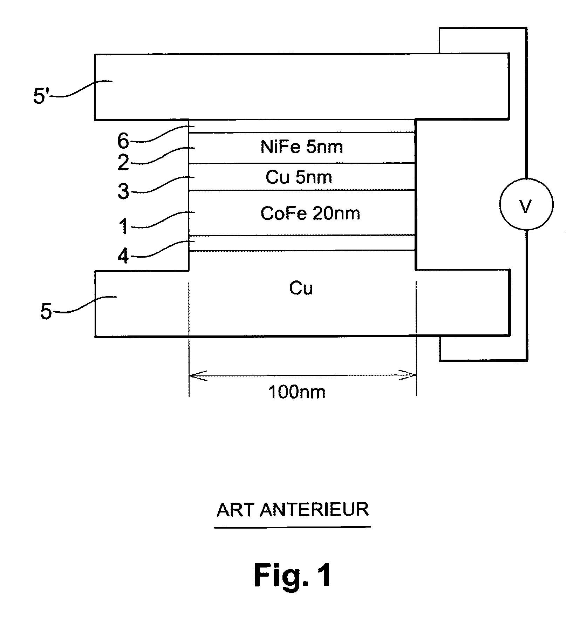

Le document US-5 695 864 décrit divers développements mettant en oeuvre le principe mentionné ci-dessus, et décrit notamment la précession de l'aimantation d'une couche magnétique traversée par un courant électrique polarisé en spin. On a représenté en relation avec la figure 1 un empilement de couches magnétiques susceptible de constituer un tel oscillateur radiofréquence. Cet empilement est inséré entre deux zones de contact électrique **5, 5',** par exemple réalisées en cuivre, en aluminium ou en or.

La couche **2** de cet empilement, dite « couche piégée », présente une aimantation à orientation fixe. Elle peut être constituée d'une couche simple, d'épaisseur typique comprise entre 5 et 100 nanomètres, et par exemple réalisée en cobalt, ou plus généralement en un alliage à base de cobalt et/ou de fer et/ou de nickel (par exemple CoFe ou NiFe). Cette couche piégée **2** peut être simple ou antiferromagnétique synthétique, c'est-à-dire constituée de deux couches ferromagnétiques couplées antiferromagnétiquement à travers un espaceur de composition et d'épaisseur appropriées, par exemple en ruthénium d'épaisseur comprise entre 0.6nm et 0.9nm. Cette couche piégée remplit la fonction de polariseur. Ainsi, les électrons du courant électrique traversant les couches constitutives du dispositif magnétorésistif perpendiculairement à leur plan, réfléchis ou transmis par le polariseur, sont polarisés avec une direction de spin parallèle à l'aimantation qu'a la couche 2 à l'interface opposée à celle en contact avec une couche antiferromagnétique **6,** à laquelle elle est associée, et destinée à figer l'orientation de son aimantation. Cette couche antiferromagnétique **6** peut être par exemple réalisée en IrMn ou FeMn ou PtMn ou NiMn.

La couche piégée **2** reçoit sur sa face opposée à la face recevant la couche antiferromagnétique **6** une autre couche **3** non magnétique faisant fonction d'espaceur. Cette couche **3** est de nature métallique, typiquement une couche de cuivre de 3 à 10 nanomètres d'épaisseur, ou est constituée d'une fine couche isolante de type oxyde d'aluminium, d'une épaisseur typique comprise entre 0,5 à 1,5 nanomètre, ou d'oxyde de magnésium, d'une épaisseur typique comprise entre 0,5 à 3 nanomètres. De l'autre côté de l'espaceur **3,** est mise en place une couche **1** dite « couche libre », généralement d'épaisseur plus faible que celle de la couche **2.** Cette couche peut être simple ou composite, c'est-à-dire formée de l'association de plusieurs couches magnétiques. Elle peut également être couplée à une couche antiferromagnétique **4** rapportée sur celle-ci au niveau de sa face opposée à l'interface de la couche **1** avec l'espaceur **3**. Elle doit simplement rester plus libre que la couche piégée. Cette couche **4** est par exemple constituée d'alliage de type Ir₈₀Mn₂₀, de FeMn ou de PtMn. Le matériau de la couche **1** est en général constitué d'un alliage à base de cobalt et/ou de fer et/ou de nickel.

On a proposé de réaliser l'empilement magnétorésistif du système ainsi décrit sous la forme d'un cylindre, constituant ainsi un nano-pilier, dont le diamètre critique est compris entre 50 et 200 nanomètres. Ainsi, avec une telle configuration et sous la seule action d'un courant continu polarisé en spin passant au travers, c'est-à-dire perpendiculairement à l'empilement de ses couches magnétiques, l'aimantation de la couche libre est amenée à subir des oscillations entretenues sous certaines conditions. Les oscillations entretenues d'aimantation apparaissent le plus souvent lorsque les effets du champ magnétique effectif agissant sur l'aimantation de la couche libre et l'effet du courant polarisé en spin traversant cette couche sont antagonistes. C'est le cas par exemple si un champ est appliqué parallèlement à l'aimantation de la couche piégée **2,** favorisant l'alignement parallèle des aimantations des couches **1** et **2** et si le courant circule de la couche piégée vers la couche libre (les électrons allant de la couche libre vers la couche piégée) ce qui favorise l'alignement antiparallèle des aimantations. Cette oscillation engendre une tension alternative de très haute fréquence via les propriétés magnétorésistives de ces systèmes. En effet, la résistance d'un alignement antiparallèle est plus grande que pour un alignement parallèle des aimantations des couches respectivement polarisantes et libres. La fréquence de cette tension est accordable via la densité de courant continu appliqué au travers de l'empilement selon une gamme de fréquences allant du gigahertz jusqu'à quelques dizaines de gigahertz avec un facteur de qualité pouvant atteindre des valeurs très importantes supérieures à 10.000.

Si sur le papier, une telle architecture est appelée à donner de bons résultats, l'expérience démontre que l'utilisation de ces oscillateurs dans des synthèses de fréquences se heurte à plusieurs verrous technologiques, dont les deux principaux sont la puissance de sortie, c'est-à-dire l'amplitude du signal utile trop faible, et des largeurs de raie trop grande, donc un faible facteur de qualité f/Δf.

S'agissant de ce dernier point, il a pu être montré que les largeurs de raie importantes sont généralement inhérentes à un manque de cohérence du mouvement de précession de l'aimantation. Ce manque de cohérence semble avoir deux origines distinctes :
- le faible volume de l'empilement magnétorésistif qui le rend plus sensible aux effets de fluctuations thermiques de l'aimantation ainsi qu'au procédé de nanofabrication (défauts au bord de l'empilement provoquant des sites de piégeage locaux de l'aimantation conduisant à des instabilités dans le mouvement de précession de l'aimantation) ;
- l'effet du champ d'Oersted ou champ ampérien (champ crée par le courant circulant dans le pilier et régi par la loi de Biot et Savard) induit par le courant appliqué qui, dans une structure cylindrique et pleine, a tendance à induire un cisaillement de l'aimantation avec une singularité au centre.

Des autres dispositifs sont connus par FR 2892871A1 ou par US 2008/0112094 A1.

L'objectif recherché par la présente invention est de proposer un oscillateur radiofréquence permettant de surmonter le problème lié au manque de cohérence du mouvement de précession de l'aimantation.

### EXPOSE DE L'INVENTION

A cet effet, l'invention propose un oscillateur radiofréquence intégrant un dispositif magnétorésistif au sein duquel est susceptible de circuler un courant électrique tel que défini par la revendication 1.

Ce dispositif comprend également des moyens aptes à faire circuler un courant d'électrons dans lesdites couches constitutives de l'empilement précité et selon une direction perpendiculaire au plan qui contient lesdites couches.

Selon l'invention, la couche libre au moins est dépourvue de toute matière en son centre et la densité de courant d'électrons circulant au travers de l'empilement desdites couches est apte à générer une aimantation dans ladite couche selon une configuration micromagnétique en forme de vortex dissymétrique circulant dans ladite couche libre autour de la zone centrale dépourvue de matière.

On montre qu'avec une telle architecture de la couche libre, dans des conditions appropriées nées d'une part, des dimensions de la couche libre, et plus particulièrement des dimensions extérieure et intérieure du secteur qu'elle définit, et d'autre part de la densité de courant d'électrons circulant dans l'empilement constitué par les couches magnétiques et par l'espaceur, l'aimantation de la couche libre prend une configuration micromagnétique de type vortex, c'est-à-dire que l'aimantation tourne le long du secteur constitutif de la couche libre en demeurant sensiblement tangent au bord dudit secteur. Le sens de rotation de l'aimantation autour du secteur (sens des aiguilles d'une montre ou sens opposé) est appelé chiralité.

Toutefois, en présence d'un courant circulant à travers l'empilement perpendiculairement aux interfaces, cette configuration de vortex peut présenter deux types de défauts de symétrie, notamment cylindrique si la couche libre adopte la forme d'un anneau, circulant dans ladite couche libre autour de la zone centrale dépourvue de matière générant l'oscillation radiofréquence recherchée: soit un changement local de chiralité du vortex, constituant une première forme de réalisation de l'invention, soit un déplacement radial du coeur du vortex, constituant une seconde forme de réalisation de l'invention, comme détaillées ci-dessous.

Les dimensions de la couche libre, et plus particulièrement les dimensions extérieure et intérieure du secteur qu'elle définit, et la densité de courant d'électrons nécessaires pour obtenir ces défauts de symétrie du vortex peuvent être évaluées à l'aide de simulateurs de micro-magnétisme communément utilisés dans le domaine. A titre d'exemple indicatif, le logiciel OOMMF (disponible à l'adresse internet http://math.nist.gov/oommf/) peut par exemple être utilisé.

Ainsi, selon une première forme de réalisation de l'invention, le défaut de symétrie du vortex peut résulter d'un changement local de chiralité dudit vortex qui se manifeste par la création d'un domaine magnétique compris entre les deux parois définissant le secteur constitutif de la couche libre. Sous l'effet du courant polarisé en spin traversant la couche libre, ce défaut local de chiralité limité par les deux parois du secteur tourne au cours du temps autour dudit secteur, pouvant ainsi provoquer une oscillation de la résistance électrique de l'empilement.

Au surplus, on observe ces oscillations même en champ appliqué nul, c'est-à-dire en l'absence de champ magnétique externe.

Selon l'invention, la couche libre peut se présenter sous la forme d'un anneau, c'est-à-dire d'un cylindre creux, défini par une paroi interne et une paroi externe.

Selon cette configuration, le diamètre interne de l'anneau est compris entre 50 et 200 nanomètres, et son diamètre externe est compris entre 200 et 500 nanomètres, grandeurs typiques facilement réalisables technologiquement et qui permettent d'avoir les performances escomptées. En outre, la fréquence d'oscillation est ajustable par la géométrie conférée à l'anneau.

Cependant, on peut conférer à la couche libre une symétrie d'ordre n, n étant un nombre entier supérieur à 1, et typiquement d'ordre 4, notamment si l'une des parois définissant le secteur est de forme carrée, ou d'ordre 6, l'une des parois définissant le secteur étant alors de forme hexagonale, voire d'ordre supérieur. Selon ces configurations, la rotation du défaut de symétrie du vortex ne tourne plus de manière régulière autour du secteur, contrairement au cas particulier où le secteur est de forme annulaire, mais avec des à-coups, et notamment des phases d'accélération et de décélération liés à la position des dissymétries de l'une au moins des parois du secteur, et notamment des angles. Ces à-coups sont susceptibles de générer des harmoniques dans le signal d'oscillations, pouvant être exploités pour atteindre des fréquences encore plus élevées que dans le cas d'un secteur de forme annulaire.

Selon l'invention, la couche ferromagnétique piégée fait fonction d'analyseur et est simple ou antiferromagnétique synthétique, et est piégée par une couche antiferromagnétique positionnée à son interface opposée à l'interface de la couche piégée avec l'espaceur.

Selon une autre caractéristique de l'invention, l'intégralité des couches constitutives de l'empilement magnétorésistif se présente sous forme d'anneaux, lesdites couches présentant sensiblement le même diamètre ; cependant, la gravure du pilier peut conduire à un léger élargissement du pied de la structure.

Selon une caractéristique de l'invention, un polariseur peut être rajouté, et positionné de manière adjacente à la couche libre, et séparé de celle-ci par un espaceur de nature métallique ou diélectrique.

La couche libre peut également être de nature antiferromagnétique synthétique.

Selon une seconde forme de réalisation de l'invention, le défaut de symétrie du vortex, nécessaire, comme déjà dit, pour obtenir l'oscillation radiofréquence, résulte du déplacement radial du coeur du vortex. Selon cette configuration, le secteur constitutif de la couche libre joue le rôle de confinement dudit vortex.

Le mouvement de giration du coeur du vortex résulte d'une part du couple de transfert de spin des électrons traversant l'empilement, et qui tend à induire un mouvement centrifuge du coeur du vortex, et d'autre part, du champ ampérien ou électrique généré par ledit courant d'électrons, qui tend à créer un potentiel attractif vers le centre du secteur.

De fait, le confinement latéral dans le secteur tend à comprimer le vortex vers le bord ou paroi extérieur du secteur, ce qui en accélère le mouvement de giration. Ainsi, on peut augmenter significativement la fréquence de précession, jusqu'à atteindre notamment plusieurs gigahertz. Ce faisant, plus la dimension extérieure du secteur est réduite, et typiquement dans le cas d'un secteur annulaire, de diamètre inférieur à 200 nanomètres, et plus la fréquence de précession augmente. Cette augmentation de la fréquence est également conditionnée avec la densité de courant d'électrons appliquée.

On a montré aussi que la fréquence de précession est également susceptible d'augmenter avec l'amortissement de GILBERT (voir la publication de Q. MISTRAL et al - « Current-driven vortex oscillations in metallic nanocontacts » - Physical Review Letter - 100, 257201 (2008)). Aussi, et selon une version avantageuse de l'invention, on dope la couche libre magnétique avec des impuretés de terres rares, et par exemple du Dy ou du Tb.

Selon cette forme de réalisation, la couche d'aimantation piégée a une aimantation planaire sensiblement monodomaine. Elle est par exemple constituée d'alliages ferromagnétiques à base de Co et/ou Fe et/ou Ni piégée par une couche antiferromagnétique par exemple en IrMn, PtMn ou NiMn.

Les variantes décrites en relation avec le premier mode de réalisation de l'invention sont également applicables à ce second mode de réalisation.

### BREVE DESCRIPTION DES FIGURES

La manière dont l'invention peut être réalisée et les avantages qui en découlent ressortiront mieux des exemples de réalisation qui suivent, donnés à titre indicatif et non limitatif, à l'appui des figures annexées, et dans lesquelles les mêmes références correspondent aux mêmes éléments.

Comme déjà dit,
la figure 1 est une représentation schématique d'un oscillateur conforme à l'état antérieur de la technique.
La figure 2 est une représentation schématique de l'empilement magnétorésistif selon une première forme de réalisation de l'invention, avec la couche libre en forme d'anneau..
La figure 3 est une illustration de la couche libre, tendant à montrer le champ d'Oersted au sein de l'anneau constitutif de la couche libre, et corollairement, l'absence de cisaillement de l'aimantation.
La figure 4 est une représentation schématique de la couche libre, tendant à illustrer la dissymétrie du vortex généré au sein de l'anneau définissant ladite couche libre.
Les figures 5, 5' et 5" sont des représentations de la couche libre selon des variantes des figures 2 et 3, présentant une symétrie d'ordre 4.
Les figures 6 et 6' sont des représentations schématiques de la couche libre selon une variante des figures 2 et 3, présentant une symétrie respectivement d'ordre 6 et d'ordre supérieur.
La figure 7 est un graphe illustrant la variation des trois composantes de l'aimantation de la couche libre en fonction du temps dans le cas d'une couche libre de forme annulaire.
Les figures 8 et 9 sont des représentations schématiques de l'empilement magnétorésistif selon une variante de la forme de réalisation de l'invention des figures 2 et 3, avec respectivement une couche libre simple et antiferromagnétique synthétique.
Les figures 10 et 11 sont des représentations schématiques de l'empilement magnétorésistif selon d'autres variantes de la forme de réalisation de l'invention illustrée aux figures 2 et 3, avec respectivement une couche libre simple et antiferromagnétique synthétique.
Les figures 12a à 12e illustrent schématiquement le procédé de réalisation d'un empilement magnétorésistif conforme à l'invention.
La figure 13 est un graphe illustrant la variation d'une composante planaire de l'aimantation en fonction du temps pour différents diamètres extérieurs de l'anneau de la couche libre.
La figure 14 est un graphe illustrant la variation de la fréquence d'oscillation en fonction du diamètre extérieur dudit anneau.
La figure 15 est une représentation schématique du fonctionnement de l'invention selon sa seconde forme de réalisation.

### MODES DE REALISATION DE L'INVENTION

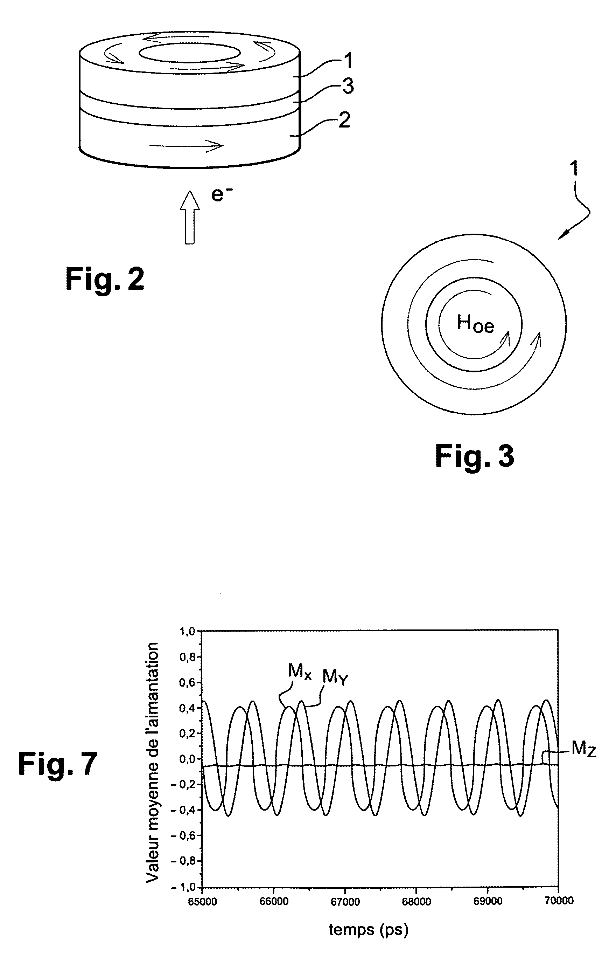

On a représenté en relation avec les figures 2 et 3, un premier mode de réalisation de l'invention, en l'espèce le plus basique. Celui-ci ne représente que le seul empilement des couches magnétiques et de l'espaceur, étant entendu, à l'instar des figures suivantes, que cet empilement est destiné à recevoir, comme illustré sur la figure 1, des zones de contact électrique permettant de faire circuler un courant d'électrons dans ledit empilement et selon une direction perpendiculaire au plan des couches qu'il contient.

Selon une première variante de cette forme de réalisation de l'invention, cet empilement se présente sous la forme d'un nano-pilier de forme sensiblement cylindrique.

Il comprend une couche libre oscillante **1** se présentant sous forme annulaire. En d'autres termes, cette couche **1** est constituée d'un cylindre creux, et donc dépourvu de matière en son centre, dont les caractéristiques dimensionnelles sont les suivantes :
- diamètre interne compris entre 50 et 200 nanomètres ;
- diamètre externe compris entre 200 et 500 nanomètres.

Cette couche libre **1** présente une épaisseur typique comprise entre 1 et 6 nanomètres. Elle est réalisée à base d'alliage de cobalt, de fer ou de nickel, tel que par exemple CoFe, CoFeB, NiFe, etc..

Cette couche libre **1** est séparée d'une couche piégée **2** par un espaceur non magnétique **3.** Dans cette forme de réalisation, la couche piégée et l'espaceur peuvent être constitués chacun par un cylindre plein ou par un cylindre creux comme la couche libre **1.**

L'espaceur **3** peut être de nature métallique, et typiquement réalisé en cuivre, dans le cas d'une vanne de spin. En revanche, il est constitué d'un matériau diélectrique, tel que Al₂O₃, MgO, SrTiO₃, HfO₂, Ta₂O₅ dans le cas d'une jonction tunnel magnétique. Il présente une épaisseur typique qui est comprise entre 1 et 2 nanomètres.

La couche piégée **2** peut être une couche simple ou antiferromagnétique synthétique. Son aimantation est fixe. Dans l'exemple de la figure 2, cette couche piégée **2** peut être, comme déjà indiqué précédemment, soit constituée d'un cylindre plein, soit constituée d'un cylindre creux comme la couche libre **1.** Elle peut être constituée d'une couche épaisse de 6 à 20 nanomètres typiquement, ou encore être couplée à une couche réalisée en un matériau antiferromagnétique, par exemple réalisée en un alliage à base de manganèse.

La couche piégée **2** sert de polariseur pour le spin des électrons de conduction et dans ce cas, les électrons passant à travers cette couche sont polarisés en spin puis vont déstabiliser et induire la précession de l'aimantation de la couche libre **1.**

On a représenté en relation avec la figure 3 l'effet de la mise en oeuvre de la couche libre sous forme annulaire. On observe ainsi la création d'un champ d'Oersted dû au courant traversant la structure toujours du même signe sur une portion de la couronne, de sorte que l'effet de cisaillement de l'aimantation que l'on observe dans les structures cylindriques pleines disparaît, contribuant ainsi à optimiser la cohérence de la rotation de l'aimantation de ladite couche libre **1.**

En outre, en raison de cette configuration de la couche libre en anneau, on observe une fermeture naturelle du flux magnétique, permettant de rendre le champ interne plus homogène le long de l'anneau : ce faisant, le mouvement de précession de l'aimantation est plus homogène et les effets de bord observés avec les dispositifs de l'art antérieur sont largement amoindris.

En outre, en raison de cette configuration en anneau, il devient possible d'augmenter le volume des couches magnétiques constitutives de l'empilement. Par ailleurs, le champ magnétique interne à la couche libre est plus homogène. Ce faisant, on aboutit à une meilleure cohérence de la dynamique de l'aimantation, et notamment une moindre influence des fluctuations thermiques sur la dynamique d'aimantation (comme décrit dans l'article « Stochastic theory of spin-transfer oscillator linewidths », Joo-Von Kim ; Phys. Rev. B 73, 174412 (2006)), et une minimisation des effets de bord liés à la nanofabrication dudit empilement.

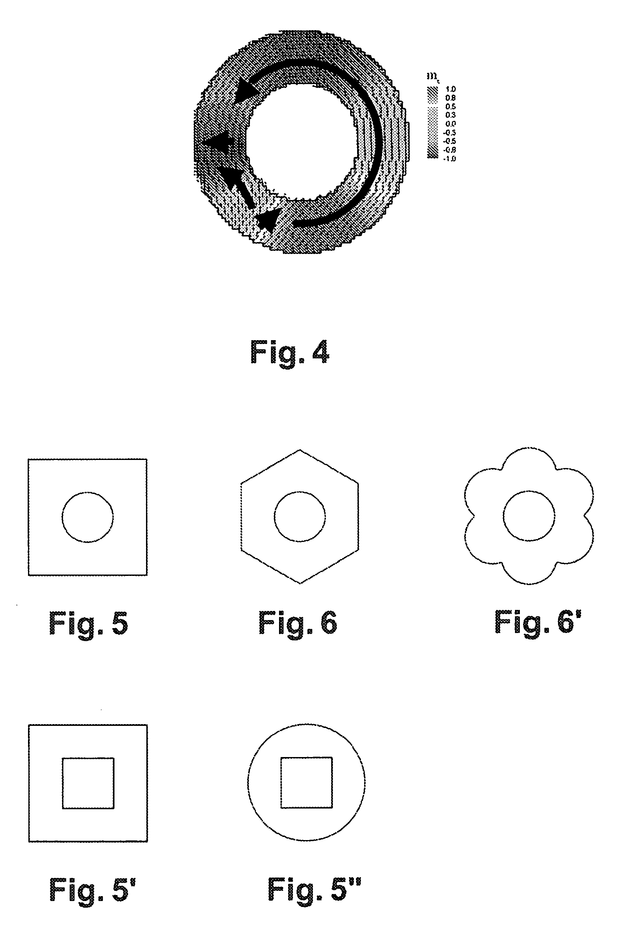

On a en outre représenté en relation avec la figure 4 la matérialisation de l'effet engendré au sein de la couche libre **1**. On peut notamment observer la chiralité du vortex généré, et plus particulièrement, la création d'un domaine magnétique compris entre deux parois magnétiques, et qui tourne autour de l'anneau. La présence de ce domaine génère un défaut de symétrie de révolution de la configuration vortex. Ce défaut consiste ici en une inversion locale de la chiralité du vortex.

On a représenté en relation avec la figure 7 la variation des trois composantes (ox, oy et oz) de l'aimantation dans la couche libre **1** en fonction du temps. On observe ainsi les oscillations générées dans les conditions suivantes :
- polariseur à aimantation perpendiculaire au plan des couches réalisé à base d'un multicouche Pt/CO₀,₄ₙₘ/t₀,₅ₙₘ)x
- espaceur séparant ce polariseur de la couche libre réalisé en cuivre ;
- couche libre d'épaisseur 3,5 nm à aimantation dans le plan des couches, de moment µMs=1,1128 T et d'amortissement de Gilbert α = 0,02, se présentant sous forme annulaire, et dont le diamètre externe est de 200 nm et le diamètre interne de 100 nm;
- espaceur séparant la couche libre de la couche piégée, réalisé en cuivre ou en diélectrique (oxyde d'aluminium ou de magnésium)
- couche piégée faisant fonction d'analyseur avec son aimantation dans le plan des couches, piégée par une couche antiferromagnétique.

On relève ainsi une oscillation à 1,45 GHz obtenue pour une densité de courant d'électrons traversant l'empilement de 15.10¹⁰ A/m².

On a observé que pour les paramètres choisis, on obtenait de telles oscillations sur une gamme de courant d'électrons comprise entre 10.10¹⁰ et 20.10¹⁰ A/m².

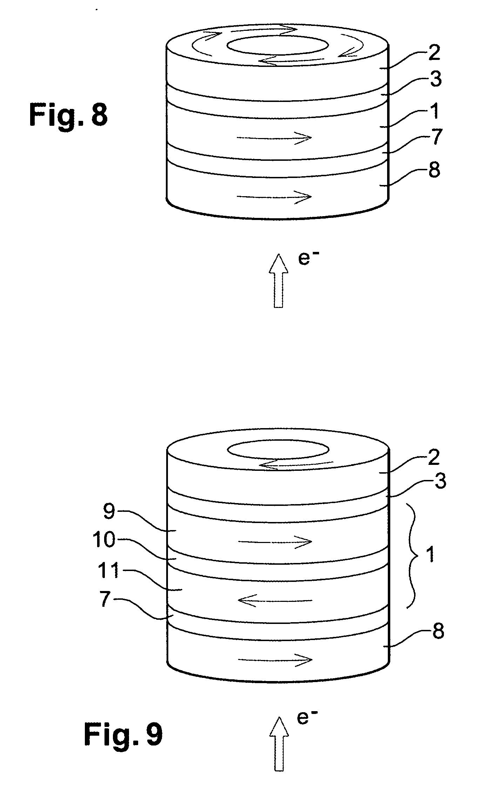

Selon une variante représentée au sein des figures 8 et 9, on adjoint à l'empilement un polariseur **8** découplé de la couche libre **1** par un espaceur **7** non magnétique, de nature métallique (en cuivre par exemple) ou isolante ou partiellement isolante et avantageusement de moindre résistance que celle de l'espaceur **3** séparant les couches **1** et **2**. De la sorte, l'effet magnétorésistif dominant produisant les variations dynamiques de tension entre le sommet et la base de l'empilement provient du sandwich formé par les couches **1, 2** et **3.** Le matériau dépend du type de polariseur : planaire ou perpendiculaire

Dans le mode de réalisation décrit en relation avec les figures 8 et 9, ce polariseur **8** a son aimantation planaire. Le matériau constitutif de ce polariseur planaire peut être Co, CoFe, CoFeB, ou encore les alliages NiCoFe, l'aimantation du polarisateur planaire pouvant être piégée par une couche antiferromagnétique de PtMn, IrMn, NiMn, FeMn.

La figure 8 illustre la mise en oeuvre d'une couche libre simple alors que la figure 9 illustre la mise en oeuvre d'une couche libre de type antiferromagnétique synthétique, et constituée de deux couches ferromagnétiques **9** et **11** couplées antiparallèlement l'une à l'autre à travers une fine couche de matériau non magnétique **10**, par exemple réalisée en ruthénium et d'épaisseur comprise entre 0.5 et 0.9 nanomètre.

Dans cette configuration, les couches ferromagnétiques **9 et 11** sont par exemple réalisées en un alliage à base de cobalt.

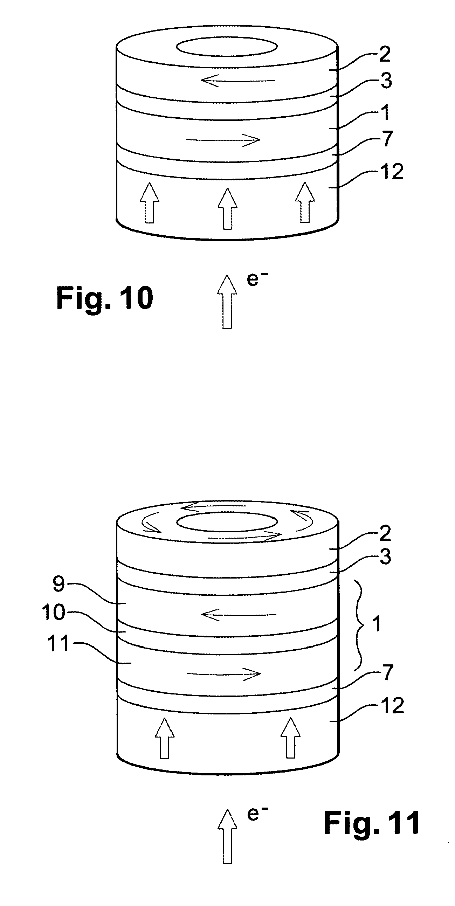

Dans une autre variante de l'invention représentée en relation avec les figures 10 et 11, on met également en oeuvre un polariseur **12**, mais dont l'aimantation est cette fois perpendiculaire par rapport au plan des couches, ce qui peut permettre de générer des oscillations en champ appliqué nul. Ce polariseur peut être constitué d'un alliage CoPt, FePt, terres rares/métaux de transition (TbCo, TbFe) ou de multicouches de type Co/Pt, Co/Ni ou Co/Pd.

La figure 10 illustre le cas où la couche libre est une couche simple et la figure 11 où la couche libre est une couche antiferromagnétique synthétique, constituée de deux couches ferromagnétiques **9** et **11** séparées par un espaceur métallique **10,** à l'instar de ce qui a été décrit en relation avec la figure 5.

Il peut également être envisagé de mettre en oeuvre un polariseur en couche continue, c'est-à-dire non pas de nature annulaire, mais constitué d'un cylindre plein. Ainsi, en faisant passer un courant suffisamment intense pendant le recuit réalisé après le dépôt des couches magnétiques constitutives de l'empilement, ledit recuit étant nécessaire pour orienter l'aimantation de la couche antiferromagnétique et donc, par couplage, assurer le piégeage de la couche piégée, on peut utiliser le champ d'Oersted pour piéger la couche continue constitutive du polariseur dans un état vortex, ce qui équivaut à recréer la configuration visée dans la figure 2. On peut obtenir le même effet en mettant en oeuvre une couche piégée très épaisse, typiquement de 50 nanomètres d'épaisseur.

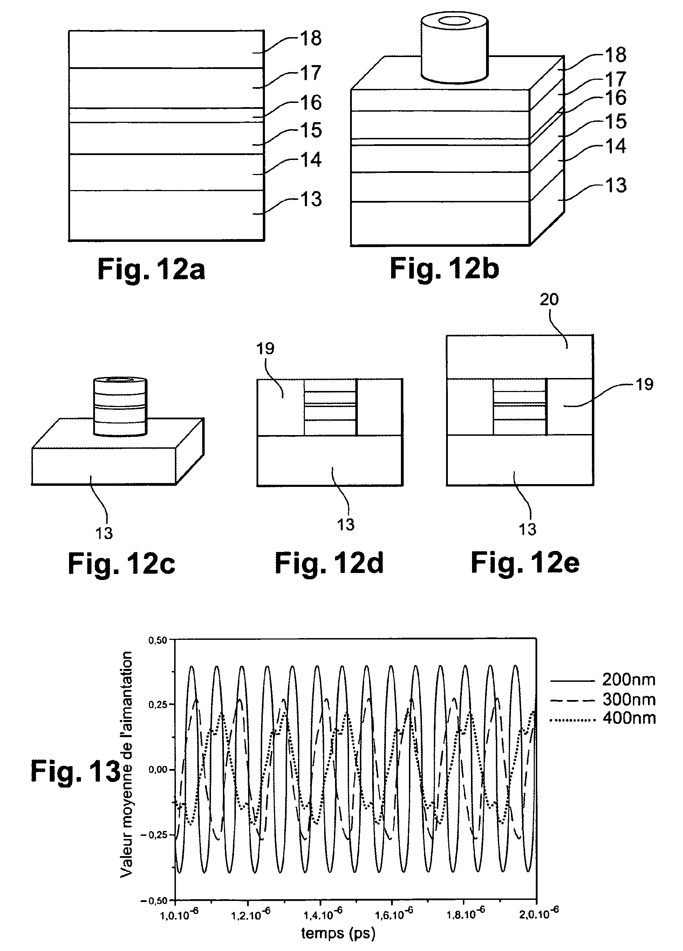

La fréquence d'oscillation est ajustable par la géométrie de l'anneau, et notamment par les valeurs respectives de son diamètre externe et de son diamètre interne. Ceci est illustré sur la figure 13 qui représente la variation d'une composante planaire de l'aimantation en fonction du diamètre extérieur de l'anneau pour les mêmes paramètres que ceux utilisés pour la figure 7.

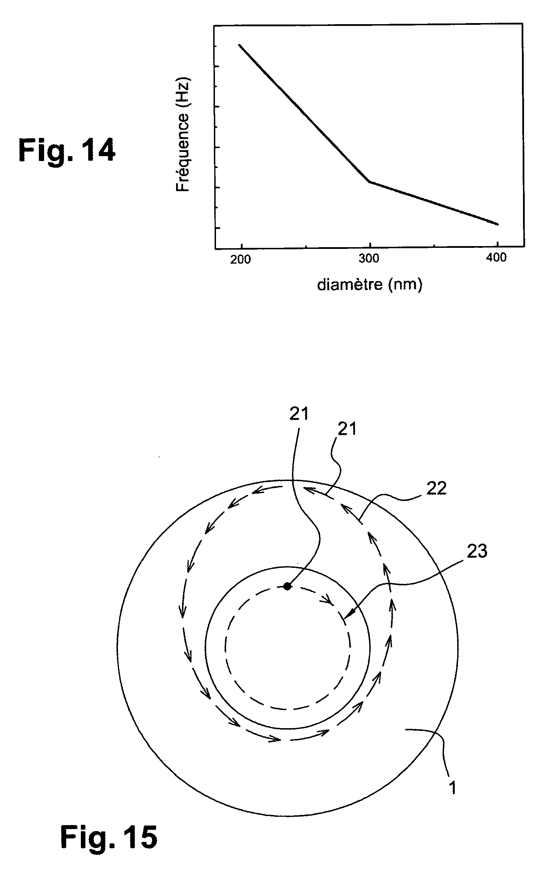

Ainsi, à distance séparant les deux diamètres constante, la fréquence diminue lorsque le diamètre externe (et donc interne) augmente. C'est ce que l'on observe par exemple au sein des figures 13 et 14.

De manière générale, la fréquence peut être ajustée en modulant la distance séparant le centre de la couche libre de la paroi externe la définissant.

Il devient donc possible de réaliser plusieurs oscillateurs oscillant à des fréquences différentes, ménagés côte à côte sur le même substrat, en faisant juste varier leur géométrie, et notamment la distance précédemment évoquée, ou, dans le cas d'une couche libre de forme annulaire, le diamètre externe de ladite couche.

On obtient ainsi un réseau d'oscillateurs radiofréquences dont la fréquence est centrée sur une valeur déterminée et différente d'un oscillateur à l'autre, que l'on peut adresser par une électronique périphérique appropriée selon la fréquence désirée. Pour chaque oscillateur, on peut faire varier la fréquence souhaitée dans une gamme restreinte en faisant simplement varier le courant de polarisation et/ou en appliquant un champ magnétique extérieur.

On a représenté en relation avec les figures 5 et 6 d'autres variantes de ce premier mode de réalisation de l'invention. Au sein des figures 5, la couche libre **1** n'est plus constituée d'un anneau régulier, c'est-à-dire défini par deux parois circulaires concentriques, mais :
- par une paroi extérieure de forme carrée et une paroi intérieure circulaire (figure 5) ;
- par deux parois, respectivement intérieure et extérieure de forme carrée (figure 5') ;
- par une paroi extérieure circulaire et une paroi intérieure de forme carrée (figure 5").

La figure 6 illustre une couche libre définie par une paroi extérieure de forme hexagonale, et par une paroi intérieure circulaire.

La figure 6' illustre une couche libre, dont la paroi extérieure est plurilobée, et la paroi intérieure circulaire.

Lorsque la couche libre se présente sous la forme d'un anneau régulier, tel que représenté par exemple au sein des figures 2 et 3, la dissymétrie du vortex tourne de manière régulière autour du centre de l'anneau, générant une oscillation de fréquence f₀ correspondant à la fréquence de rotation de la zone de chiralité différente dudit vortex.

Dans le cas des configurations illustrées aux figures 5, à la figure 6 et à la figure 6', dans lesquelles la symétrie de la couche libre est respectivement d'ordre 4 et d'ordre 6, la rotation du défaut de symétrie du vortex est modifiée, dans la mesure où ce dernier ne tourne plus régulièrement, comme dans le cas de l'anneau des figures 2 et 3, mais avec des phases d'accélération et de décélération liées aux dissymétries générées soit par la paroi extérieure, soit par la paroi intérieure. Ces phases successives génèrent des harmoniques dans le signal d'oscillations de fréquence respective 4.f₀ et 6.f₀ (voire n.f₀ si symétrie d'ordre n), susceptibles d'être exploitées afin d'atteindre des fréquences encore plus élevées.

Un mode de réalisation de l'empilement magnétorésistif constitutif du premier mode de réalisation de l'invention est décrit en relation avec les figures 12a à 12e.

Une fois l'empilement magnétique, en l'espèce constituée d'une couche antiferromagnétique de type PtMn ou IrMn **14,** d'une couche ferromagnétique **15** constituée d'un alliage à base de cobalt , d'une barrière tunnel **16** constituée d'un oxyde du type AlOx, SrTiO₃, ou MgO, et enfin d'une couche ferromagnétique **17,** par exemple réalisée également à base de cobalt, déposé (par exemple par pulvérisation cathodique) sur l'électrode inférieure **13,** par exemple réalisé en cuivre ou en or, on dépose une couche **18** par exemple réalisée en tantale, constitutive d'un masque dur, destiné à s'opposer à l'action de la gravure intervenant subséquemment et donc à protéger provisoirement l'empilement magnétique lors de ladite étape de gravure (figure 12a).

On dépose ensuite sur cet empilement une résine au dessus du masque dur (figure 12b) selon une zone correspondant à la dimension recherchée du nano-plot que l'on souhaite réaliser. A cet effet, la résine est déposée pleine plaque puis insolée par traitement UV à travers un masque de chrome, ou insolée par un faisceau d'électrons dans un masqueur « *e-beam* », pour définir la forme de cylindre creux que l'on souhaite donner à l'empilement déposé.

L'ensemble est alors soumis à une gravure propre à évacuer le masque dur et les différentes couches constitutives de l'empilement jusqu'à l'électrode inférieure, sauf sur les parties protégées par la couronne de résine et le masque dur, afin de définir la dimension et notamment les diamètres internes et externes du plot (figure 12c). Cette gravure peut être par exemple réalisée par IBE (« *Ion Beam Etching* ») ou encore par RIE (« *Reactive Ion Etching* »).

On procède alors à l'encapsulation de l'ensemble résultant de cette dernière étape, cette encapsulation étant réalisée au moyen d'un matériau diélectrique **19** de type silice ou alumine. Le dépôt de cette encapsulation peut être réalisée par dépôt PVD (selon l'acronyme anglo-saxon « *Physical Vapor Deposition* ») (figure 12d).

On procède alors à une étape de planarisation, par exemple par CMP (Polissage Mécano Chimique - selon l'acronyme anglo-saxon « *Chemical mechanical polishing* »), jusqu'à aboutir au niveau supérieur du nano-plot à l'obtention d'une surface plane apte à recevoir l'électrode supérieure **20**.

On procède alors au dépôt du matériau métallique destiné à constituer l'électrode supérieure puis à une étape de lithographie et de gravure pour définir la forme de l'électrode supérieure, et enfin au retrait de la résine, par exemple par voie chimique, pour aboutir à l'oscillateur.

On a représenté en relation avec la figure 15 le principe du fonctionnement de l'invention selon le second mode de réalisation.

On a notamment illustré le déplacement radial du coeur **21** du vortex, constituant le défaut de symétrie recherché propre à générer les oscillations. Comme on peut l'observer, le coeur **21** du vortex **22** ne coïncide pas avec le centre de l'anneau constitutif de la couche libre, mais suit une orbite **23** concentrique par rapport audit centre.

Corollairement, le vortex est confiné par l'anneau, ainsi qu'illustré par le tracé excentré **24** dudit vortex.

Dans ce mode de réalisation, c'est la giration du coeur du vortex autour du centre de l'anneau qui génère l'oscillation recherchée. En modifiant la géométrie de l'anneau, et notamment en jouant sur ses diamètres, respectivement intérieur et extérieur, et en outre en jouant sur la densité de courant d'électrons traversant l'empilement perpendiculairement au plan des couches qui le constitue, on peut moduler la vitesse de giration du coeur du vortex, et corollairement la fréquence des oscillations.

Comme pour le premier mode de réalisation, il est possible de donner à la couche magnétique libre des formes de symétrie d'ordre n telles que illustrées sur les figures 5, 5', 5", 6, 6' afin de générer des harmoniques d'ordre n de la fréquence fondamentale.

On conçoit de fait la facilité de réalisation d'un tel oscillateur, qui présente des propriétés améliorées en termes de synthèse de fréquence et d'accordabilité, compte tenu notamment de la plus grande cohérence de rotation de l'aimantation de la couche libre.

## Revendications

1. Oscillateur radiofréquence intégrant un dispositif magnétorésistif au sein duquel est susceptible de circuler un courant d'électrons, ledit dispositif comprenant :
- une première couche magnétique, dite « couche piégée » (2), dont l'aimantation est de direction sensiblement fixe ;
- une seconde couche magnétique dite « couche libre » (1) ;
- une couche amagnétique (3), dite « couche intermédiaire » ou espaceur, interposée entre la couche libre (1) et la couche piégée (2) ;
l'oscillateur comprenant également des moyens (13, 20) aptes à faire circuler un courant d'électrons dans lesdites couches constitutives de l'empilement précité et selon une direction perpendiculaire au plan qui contient lesdites couches,
***caractérisé :***
- **en ce que** la couche libre (1) au moins est dépourvue de toute matière en son centre et,
- **en ce que** les moyens aptes à faire circuler un courant d'électrons génèrent un courant circulant au travers de l'empilement desdites couches dont la densité est apte à générer une aimantation dans ladite couche libre selon une configuration micromagnétique en forme de vortex dissymétrique circulant dans ladite couche libre autour de la zone centrale dépourvue de matière.

2. Oscillateur radiofréquence selon la revendication 1, ***caractérisé* en ce que** la couche libre (I) est en forme d'anneau, c'est-à-dire d'un cylindre creux, défini par une paroi interne et une paroi externe.

3. Oscillateur radiofréquence selon la revendication 2, ***caractérisé* en ce que** le diamètre interne de l'anneau est compris entre 50 et 200 nanomètres, et **en ce que** son diamètre externe est compris entre 200 et 500 nanomètres.

4. Oscillateur radiofréquence selon l'une des revendications 2 et 3, ***caractérisé* en ce que** l'intégralité des couches constitutives de l'empilement se présente sous la forme d'un anneau.

5. Oscillateur radiofréquence selon la revendication 1, ***caractérisé* en ce que** la couche libre (1) présente une forme de symétrie d'ordre n, n étant un nombre entier supérieur à 1, résultant du profil de la paroi extérieure et/ou de la paroi intérieure la définissant.

6. Oscillateur radiofréquence selon l'une des revendications 1 à 5, ***caractérisé* en ce que** la couche piégée (2) est ferromagnétique, et fait en outre fonction d'analyseur pour le courant d'électrons susceptible de la traverser.

7. Oscillateur radiofréquence selon la revendication 6, ***caractérisé* en ce que** la couche piégée (2) est simple, **en ce qu'**elle est réalisée en cobalt, ou plus généralement en un alliage à base de cobalt et/ou de fer et/ou de nickel (CoFe ou NiFe), et **en ce qu'**elle est piégée par une couche antiferromagnétique positionnée à son interface opposée à l'interface de la couche piégée (2) avec l'espaceur (3).

8. Oscillateur radiofréquence selon la revendication 6, ***caractérisé* en ce que** la couche piégée (2) est antiferromagnétique synthétique.

9. Oscillateur radiofréquence selon l'une des revendications 1 à 8, ***caractérisé* en ce que** l'empilement magnétorésistif comporte en outre un polariseur (8, 12), découplé de la couche libre (1) par un espaceur (7) réalisé en un matériau métallique ou diélectrique.

10. Oscillateur radiofréquence selon la revendication 9, ***caractérisé* en ce que** le polariseur (12) est constitué d'une couche réalisée en un alliage de cobalt et de platine ou de palladium, ou est constitué d'une alternance de multicouches Co/Pt ou Co/Pd ou Co/Ni, et dont l'aimantation est orientée perpendiculairement au plan des couches.

11. Oscillateur radiofréquence selon l'une des revendications 1 à 10, ***caractérisé* en ce que** la couche intermédiaire ou espaceur (3) est de nature métallique, et par exemple en cuivre, ou est constitué d'une barrière tunnel, et par exemple constituée d'un oxyde du type Al₂O₃, MgO, SrTiO₃, HfO₂, Ta₂O₅.

12. Oscillateur radiofréquence selon l'une des revendications 1 à 11, ***caractérisé* en ce que** la couche libre (1) est dopée en impuretés choisies dans les Terres Rares, et notamment en Dy ou en Tb.

13. Procédé pour ajuster la fréquence d'un oscillateur radiofréquence réalisé conformément à l'une des revendications 1 à 12, consistant à moduler la distance séparant le centre de la couche libre de la paroi externe la définissant, et notamment, le diamètre externe de la couche libre lorsque celle-ci est constituée d'un anneau.

14. Procédé pour ajuster la fréquence d'un oscillateur radiofréquence selon la revendication 13, ***caractérisé* en ce qu'**il consiste en outre à moduler la densité de courant d'électrons traversant l'empilement constitutif de l'oscillateur.

15. Procédé pour ajuster la fréquence d'un oscillateur radiofréquence selon la revendication 14, *caractéricé* en ce que la densité de courant est comprise entre 10.10¹⁰ et 20.10¹⁰ A/m².

16. Réseau d'oscillateurs radiofréquences comprenant sur un même substrat un ensemble d'oscillateurs radiofréquences selon les revendications 1 à 12 dans lequel la distance séparant le centre de la couche libre de la paroi externe la définissant, et notamment, le diamètre externe de la couche libre lorsque celle-ci est constituée d'un anneau diffère d'un oscillateur à l'autre, aux fins de conférer auxdits oscillateurs une fréquence d'oscillation différente.

## Claims

1. A radio-frequency oscillator incorporating a magnetoresistive device within which an electron current is able to flow, said device comprising:
- a first magnetic layer, known as a "trapped layer" (2), the magnetization of which is of substantially fixed direction;
- a second magnetic layer known as a "free layer" (1);
- a non-magnetic layer (3), known as an "intermediate layer" or spacer, interposed between the free layer (1) and the trapped layer (2);
the oscillator also comprising means (13, 20) capable of making an electron current flow in said layers constituting the aforementioned stack and in a direction perpendicular to the plane which contains said layers,
**characterized :**
- **in that** at least the free layer (1) is devoid of any material at its centre and,
- **in that** the means capable of making an electron current flow generate a current flowing through the stack of said layers whereof the density is capable of generating a magnetization in said free layer in a micromagnetic configuration in the shape of a skewed vortex flowing in said free layer around the central zone devoid of material.

2. The radio-frequency oscillator as claimed in claim 1, wherein the free layer (1) is in the shape of a ring, in other words a hollow cylinder, defined by an inner wall and an outer wall.

3. The radio-frequency oscillator as claimed in claim 2, wherein the internal diameter of the ring is between 50 and 200 nanometres, and wherein its external diameter is between 200 and 500 nanometres.

4. The radio-frequency oscillator as claimed in any one of claims 2 and 3, wherein all the layers constituting the stack are in the form of a ring.

5. The radio-frequency oscillator as claimed in claim 1, wherein the free layer (1) has an order n symmetry shape, n being a whole number higher than 1, resulting from the profile of the outer wall and/or the inner wall defining it.

6. The radio-frequency oscillator as claimed in any one of claims 1 to 5, wherein the trapped layer (2) is ferromagnetic, and additionally functions as an analyzer for the electron current able to pass through it.

7. The radio-frequency oscillator as claimed in claim 6, wherein the trapped layer (2) is single, wherein it is made of cobalt, or more generally of a cobalt- and/or iron- and/or nickel-based alloy (CoFe or NiFe), and wherein it is trapped by an anti-ferromagnetic layer positioned at its interface opposite the interface of the trapped layer (2) with the spacer (3).

8. The radio-frequency oscillator as claimed in claim 6, wherein the trapped layer (2) is synthetic anti-ferromagnetic.

9. The radio-frequency oscillator as claimed in any one of claims 1 to 8, wherein the magnetoresistive stack further comprises a polarizer (8, 12), decoupled from the free layer (1) by a spacer (7) made of a metallic or dielectric material.

10. The radio-frequency oscillator as claimed in claim 9, wherein the polarizer (12) is constituted by a layer made of a cobalt or platinum or palladium alloy, or is constituted by an alternation of Co/Pt or Co/Pd or Co/Ni multi-layers, the magnetization of which is directed perpendicular to the plane of the layers.

11. The radio-frequency oscillator as claimed in any one of claims 1 to 10, wherein the intermediate layer or spacer (3) is metallic in nature, and for example of copper, or is constituted by a tunnel barrier, and for example constituted by an oxide such as Al₂O₃, MgO, SrTiO₃, HfO₂, Ta₂O₅.

12. The radio-frequency oscillator as claimed in any one of claims 1 to 11, wherein the free layer (1) is doped with impurities selected from the Rare Earths, and particularly with Dy or Tb.

13. A process for adjusting the frequency of a radio-frequency oscillator produced in accordance with one of claims 1 to 12, comprising modulating the distance separating the centre of the free layer from the outer wall defining it, and in particular, the external diameter of the free layer when it is constituted by a ring.

14. The process for adjusting the frequency of a radio-frequency oscillator as claimed in claim 13, wherein it further comprises modulating the electron current density flowing though the stack constituting the oscillator.

15. The process for adjusting the frequency of a radio-frequency oscillator as claimed in claim 14, wherein the current density is between 10.10¹⁰ and 20.10¹⁰ A/m².

16. A network of radio-frequency oscillators comprising on one and the same substrate a set of radio-frequency oscillators as claimed in claims 1 to 12 wherein the distance separating the centre of the free layer from the outer wall defining it, and in particular, the external diameter of the free layer when it is constituted by a ring varies from one oscillator to another, in order to confer on said oscillators a different oscillation frequency.

## Patentansprüche

1. Funkfrequenzoszillator, in den eine magnetoresistive Vorrichtung integriert ist, in der ein Elektronenstrom fließen kann, wobei die Vorrichtung umfasst:
- eine erste magnetische Schicht, die "eingeschlossene Schicht" (2) genannt wird, deren Magnetisierung von im Wesentlichen feststehender Richtung ist;
- eine zweite magnetische Schicht, die "freie Schicht" (1) genannt wird;
- eine nicht magnetische Schicht (3), die "Zwischenschicht" oder Abstandhalter genannt wird, die zwischen der freien Schicht (1) und der eingeschlossenen Schicht (2) eingesetzt ist;
wobei der Oszillator auch Einrichtungen (13, 20) umfasst, die einen Elektronenstrom in den die vorgenannte Stapelung bildenden Schichten in einer Richtung senkrecht zur Ebene, die die Schichten enthält, fließen lassen können,
**dadurch gekennzeichnet**
- **dass** zumindest die freie Schicht (1) in ihrer Mitte frei von jeglichem Material ist, und
- **dass** die Einrichtungen, die einen Elektronenstrom fließen lassen können, einen durch die Stapelung der Schichten fließenden Strom erzeugen, dessen Dichte eine Magnetisierung in der freien Schicht entsprechend einer mikromagnetischen Konfiguration in Form eines asymmetrischen Scheitelpunkts erzeugen kann, die in der freien Schicht um den materialfreien mittleren Bereich zirkuliert.

2. Funkfrequenzoszillator nach Anspruch 1, **dadurch gekennzeichnet, dass** die freie Schicht (1) in Form eines Rings, d.h. eines Hohlzylinders, vorliegt, der durch eine Innenwand und eine Außenwand definiert ist.

3. Funkfrequenzoszillator nach Anspruch 2, **dadurch gekennzeichnet, dass** der Innendurchmesser des Rings zwischen 50 und 200 Nanometer beträgt, und dass sein Außendurchmesser zwischen 200 und 500 Nanometer beträgt.

4. Funkfrequenzoszillator nach einem der Ansprüche 2 und 3, **dadurch gekennzeichnet, dass** die Gesamtheit der die Stapelung bildenden Schichten sich in Form eines Rings darstellt.

5. Funkfrequenzoszillator nach Anspruch 1, **dadurch gekennzeichnet, dass** die freie Schicht (1) eine Symmetrieform einer Ordnung n, wobei n eine ganze Zahl größer als 1 ist, aufweist, die sich aus dem Profil der sie definierenden Außenwand und/oder Innenwand ergibt.

6. Funkfrequenzoszillator nach einem der Ansprüche 1 bis 5, **dadurch gekennzeichnet, dass** die eingeschlossene Schicht (2) ferromagnetisch ist und außerdem als Analysator für den Elektronenstrom dient, der sie durchfließen kann.

7. Funkfrequenzoszillator nach Anspruch 6, **dadurch gekennzeichnet, dass** die eingeschlossene Schicht einfach ist, dass sie aus Kobalt oder allgemeiner aus einer Legierung auf Basis von Kobalt und/oder Eisen und/oder Nickel (CoFe oder NiFe) hergestellt ist, und dass sie von einer antiferromagnetischen Schicht eingeschlossen ist, die an ihrer Grenzfläche angeordnet ist, die der Grenzfläche der eingeschlossenen Schicht (2) mit dem Abstandhalter (3) entgegengesetzt ist.

8. Funkfrequenzoszillator nach Anspruch 6, **dadurch gekennzeichnet, dass** die eingeschlossene Schicht (2) antiferromagnetisch synthetisch ist.

9. Funkfrequenzoszillator nach einem der Ansprüche 1 bis 8, **dadurch gekennzeichnet, dass** die magnetoresistive Stapelung darüber hinaus einen Polarisator (8, 12) umfasst, der von der freien Schicht (1) durch einen Abstandhalter (7) abgekoppelt ist, der aus einem metallischen oder dielektrischen Material hergestellt ist.

10. Funkfrequenzoszillator nach Anspruch 9, **dadurch gekennzeichnet, dass** der Polarisator (12) aus einer Schicht besteht, die aus einer Legierung aus Kobalt und Platin oder Palladium hergestellt ist oder aus abwechselnden Mehrfachschichten aus Co/Pt oder Co/Pd oder Co/Ni besteht, und dessen Magnetisierung senkrecht zur Ebene der Schichten ausgerichtet ist.

11. Funkfrequenzoszillator nach einem der Ansprüche 1 bis 10, **dadurch gekennzeichnet, dass** die Zwischenschicht oder der Abstandhalter (3) von metallischer Beschaffenheit und beispielsweise aus Kupfer ist, oder aus einer Tunnelsperrschicht besteht, und beispielsweise aus einem Oxid der Art Al₂O₃, MgO, SrTiO₃, HfO₂, Ta₂O₅ besteht.

12. Funkfrequenzoszillator nach einem der Ansprüche 1 bis 11, **dadurch gekennzeichnet, dass** die freie Schicht (1) mit Fremdstoffen, die aus seltenen Erden ausgewählt sind, und insbesondere mit Dy oder Tb dotiert ist.

13. herfahren zum Einstellen der Frequenz eines nach einem der Ansprüche 1 bis 12 ausgeführten Funkfrequenzoszillators, das darin besteht, den Abstand, der die Mitte der freien Schicht von der sie definierenden Außenwand trennt, und insbesondere den Außendurchmesser der freien Schicht, wenn diese aus einem Ring besteht, zu modulieren.

14. Verfahren nach Anspruch 13 zum Einstellen der Frequenz eines Funkfrequenzoszillators, **dadurch gekennzeichnet, dass** es darin besteht, darüber hinaus die Dichte des Elektronenstroms zu modulieren, der die den Oszillator bildende Stapelung durchfließt.

15. verfahren nach Anspruch 14 zum Einstellen der Frequenz eines Funkfrequenzoszillators, **dadurch gekennzeichnet, dass** die Stromdichte zwischen 10.10¹⁰ und 20.10¹⁰ A/m² beträgt.

16. Funkfrequenzoszillatornetz, das auf ein und demselben Substrat eine Einheit von Funkfrequenzoszillatoren nach den Ansprüchen 1 bis 12 umfasst, in dem der Abstand, der die Mitte der freien Schicht von der sie definierenden Außenwand trennt, und insbesondere der Außendurchmesser der freien Schicht, wenn diese aus einem Ring besteht, sich von einem Oszillator zum nächsten unterscheidet, um den Oszillatoren eine unterschiedliche Schwingungsfrequenz zu verleihen.
